# FASCICULE DE BREVET EUROPEEN

(11) **EP 0 324 677 B1**
(45) Date de publication et mention de la délivrance du brevet: **14.07.1993**
(21) Numéro de dépôt: 89400066.0
(22) Date de dépôt: 10.01.1989
(51) Int. Cl.: H04N 3/15, H01L 27/14

(54) **Matrice photosensible à trois diodes par point, sans remise à niveau**
Photoempfindliche Matrix mit drei Dioden pro Punkt ohne Rückstellung
Three diodes photosensitive matrix, without resetting

(30) Priorité: 15.01.1988 FR 8800412
(43) Date de publication de la demande: 19.07.1989
(73) Titulaire: THOMSON-CSF, 75008 Paris (FR)
(72) Inventeur: Arques, Marc, F-75008 Paris (FR); Berger, Jean-Luc, F-75008 Paris (FR)
(74) Mandataire: Guérin, Michel

(56) Documents cités:
- EP-A- 0 046 396
- DE-A- 1 938 395
- FR-A- 2 593 343

## Description

L'invention concerne les matrices d'éléments photosensibles.

Pour réaliser des matrices d'éléments photosensibles, il est classique de prévoir un réseau de conducteurs en ligne, et un réseau de conducteurs en colonne, avec, à chaque croisement d'une ligne et d'une colonne, un élément photosensible respectif. Par le réseau de lignes on sélectionne une ligne d'éléments photosensibles dont on veut connaître les signaux électriques de sortie; par le réseau de conducteurs de colonnes, on lit un signal de sortie respectif pour chacun des éléments de la ligne sélectionnée.

Dans la demande de brevet français FR-A-2 593 343, on a décrit une matrice photosensible comportant un réseau de points photosensibles dans lequel chaque point photosensible comprend une capacité de stockage de charges en série avec un élément photosensible, l'ensemble étant connecté entre un conducteur de ligne et un conducteur de colonne; l'élément photosensible peut être une photodiode PIN à trois couches (couche semiconductrice de type P, couche intrinsèque I, couche de type N).

Des charges sont engendrées dans la photodiode par l'éclairement du point photosensible. Elles s'accumulent sur le noeud (flottant) entre la photodiode et la capacité. Elles sont lues par application au conducteur de ligne d'une impulsion de tension dans un sens qui polarise la photodiode en direct (alors qu'elle était polarisée en inverse pendant la phase d'accumulation). Des charges en quantité correspondant aux charges accumulées sont alors transférées du noeud flottant vers la colonne (ou inversement de la colonne vers le noeud flottant); la lecture consiste à mesurer ce mouvement de charges.

Après la fin de l'impulsion de lecture, la photodiode se bloque pour une nouvelle phase d'éclairement et d'intégration de charges.

Mais le potentiel du noeud flottant n'est plus à la valeur qu'il avait au début de la phase d'intégration; on ne peut donc pas commencer une nouvelle phase d'intégration sans établir à une valeur de départ bien déterminée ce potentiel du noeud flottant.

La phase de lecture est donc suivie d'une phase de remise à niveau du potentiel du noeud flottant.

La remise à niveau se fait par éclairement intense de la photodiode. Il est donc nécessaire de prévoir une source d'éclairement et des moyens de commande synchronisés avec les moyens de lecture de la matrice photosensible pour effectuer une remise à niveau après chaque phase de lecture.

D'autre part, les matrices décrites ci-dessus, utilisant comme point photosensible un ensemble en série d'une photodiode et d'une capacité, nécessitent que l'éclairement soit discontinu, c'est-à-dire que la matrice soit dans l'obscurité pendant le temps réservé à la lecture du signal fourni par les points photosensibles.

La présente invention propose une nouvelle structure de point photosensible qui élimine la nécessité d'une source d'éclairement de remise à niveau et qui permet d'acquérir l'information en flux continu sans qu'il soit nécessaire de mettre la matrice dans l'obscurité pendant la lecture.

Selon l'invention, on propose une matrice de points photosensibles comportant un réseau de points photosensibles agencés en lignes (au moins une ligne) et en colonnes (au moins une colonne), chaque point photosensible étant situé au carrefour d'une ligne et d'une colonne et étant apte à intégrer, entre deux phases de lecture successives, des charges électriques résultant de l'éclairement de ce point, caractérisé en ce que chaque point photosensible comprend trois diodes reliées à un noeud commun flottant, une première diode dite diode photosensible étant reliée entre un conducteur de ligne et le noeud flottant pour engendrer lorsqu'elle est éclairée des charges électriques sur le noeud flottant, une deuxième diode, dite diode de lecture, reliée entre le noeud flottant et un conducteur de colonne pour permettre un transfert entre ce conducteur de colonne et le noeud flottant d'une quantité de charges correspondant à la quantité de charges générées par l'éclairement entre deux phases de lecture successives du point, et une troisième diode, dite diode de remise à niveau, connectée entre le noeud flottant et un conducteur relié à une source de tension de remise à niveau, pour rétablir à une valeur choisie le potentiel du noeud flottant après ledit transfert de charges.

Dans une réalisation particulière, la source de remise à niveau est une source de potentiel de référence fixe.

Dans ce cas, on prévoit de préférence que l'anode de la diode photosensible, l'anode de la diode de lecture et la cathode de la diode de remise à niveau sont reliées au noeud flottant, ou inversement que la cathode de la diode photosensible, la cathode de la diode de lecture et l'anode de la diode de remise à niveau sont reliées au noeud flottant.

Dans cette réalisation, non seulement il n'y a pas besoin de source de lumière pour remettre à niveau le potentiel du noeud flottant, mais il n'y a même pas besoin d'engendrer un signal électrique de remise à niveau spécifique; la seule présence de la source de tension fixe suffit à rétablir le potentiel flottant au niveau désiré.

Dans une autre réalisation, la source de tension de remise à niveau est reliée à un autre conducteur de ligne; un moyen est prévu pour appliquer sur le conducteur de ligne relié à la diode photosensible une impulsion de lecture à la fin d'une période d'intégration de charges; un autre moyen est prévu pour appliquer sur l'autre conducteur de ligne une impulsion de tension de remise à niveau après l'impulsion de lecture.

Dans ce cas, on prévoit de préférence que la cathode de la diode photosensible, l'anode de la diode de lecture et la cathode de la diode de remise à niveau sont connectées au noeud flottant, ou inversement que l'anode de la diode photosensible, la cathode de la diode de lecture et l'anode de la diode de remise à niveau sont reliées au noeud flottant.

Cette disposition a l'avantage de permettre que la charge lue sur une colonne est d'autant plus forte que l'éclairement est plus faible, et également l'avantage de permettre le transfert d'une charge minimale non nulle dans tous les cas d'éclairement (d'un éclairement nul à un éclairement de saturation).

On peut alors aussi prévoir que l'autre conducteur de ligne mentionné est le conducteur de ligne relié à une diode photosensible d'un point photosensible correspondant à une autre ligne de points photosensibles de la matrice. Dans certains cas, cette autre ligne sera adjacente à la première, mais on peut aussi envisager qu'elle ne le soit pas, en particulier dans des cas où on veut pouvoir faire une lecture de la matrice avec un balayage entrelacé des lignes. Ces réalisations permettent d'éviter d'avoir deux conducteurs de ligne pour chaque point de la matrice.

Dans une autre réalisation, on prévoit que le conducteur de remise à niveau est relié à une source de tension constante, qui est la même pour tous les points photosensibles, et que l'on applique sur le conducteur de ligne un signal périodique à trois niveaux de tension différents qui sont respectivement un premier niveau pendant une phase d'intégration, un deuxième niveau pendant une phase de lecture, et un troisième niveau pendant une phase de remise à niveau. Cette disposition permet à la fois d'éviter la présence d'un deuxième conducteur de ligne pour chaque ligne de points photosensibles et de fournir une quantité de charges électriques d'autant plus importante que l'éclairement est faible. Dans ce cas, on prévoit de préférence que la cathode de la diode photosensible, l'anode de la diode de lecture, et la cathode de la diode de remise à niveau sont reliées au noeud flottant, ou réciproquement que l'anode de la diode photosensible, la cathode de la diode de lecture, et l'anode de la diode de remise à niveau sont reliées au noeud flottant

Enfin, dans certains cas, on effectuera la lecture par application d'une impulsion de lecture sur une ligne, toutes les colonnes étant à un potentiel de référence; mais dans d'autres cas, on pourra appliquer sur une ligne une impulsion de lecture d'un signe par rapport au potentiel de référence des colonnes et simultanément une impulsion de lecture de signe opposé sur un conducteur de colonne spécifié relié au point photosensible dont on veut lire les charges, les autres conducteurs de colonne étant maintenus au potentiel de référence. Cette disposition permet de sélectionner facilement une colonne de points photosensibles.

L'invention est applicable à toutes sortes de matrices photosensibles, y compris celles qui sont utilisées en radiologie et qui comportent de ce fait un scintillateur (oxyde de gadolinium, iodure de césium, etc.) pour convertir un rayonnement X (ou gamma, ou neutronique, etc.) en rayonnemnt lumineux dans la bande de longueurs d'onde auxquelles les photodiodes sont sensibles.

L'invention se prête particulièrement à une réalisation dans laquelle les points photosensibles sont réalisés par superposition de couches de silicium amorphe.

Parmi les avantages que l'on escompte de la présente invention, car ils sont essentiels pour la qualité des matrices réalisées, on peut mentionner:
- la faible capacité des colonnes de points photosensibles,
- la rapidité de la lecture,
- le bon découplage entre les points photosensibles de lignes ou colonnes voisines,
- la réduction de bruit parasite au moment de la lecture, bruit qui pouvait être généré dans les systèmes antérieurs par la mise en conduction directe de la diode photosensible; ici, la photodiode reste en principe toujours polarisée en inverse, même pendant la lecture.

D'autres caractéristiques et avantages de l'invention apparaîtront à la lecture de la description détaillée qui suit et qui est faite en référence aux dessins annexés dans lesquels:
- la figure 1 représente une matrice de points photosensibles selon l'invention;
- la figure 2 représente les diagrammes temporels de variation des potentiels respectivement sur le premier conducteur de ligne, le deuxième conducteur de ligne et le noeud commun flottant, pour le mode de réalisation de la figure 1;
- la figure 3 représente une courbe de variation de la quantité de charges lues sur la colonne en fonction de l'éclairement;
- la figure 4 représente des diagrammmes temporels de potentiels pour une variante de fonctionnement du circuit de la figure 1;
- la figure 5 représente la courbe de variation de la quantité de charges lues en fonction de l'éclairement, pour le mode de fonctionnement de la figure 4.
- la figure 6 représente une variante de réalisation utilisant le mode de fonctionnement de la figure 4;
- la figure 7 représente un autre mode de réalisation de la matrice photosensible selon l'invention, dans lequel la remise à niveau après lecture se fait non pas par une impulsion de tension mais par une source de tension continue;
- la figure 8 est un diagramme temporel explicatif montrant les variations de potentiel du noeud flottant dans le mode de réalisation de la figure 7.
- la figure 9 représente un autre mode de réalisation dans lequel la remise à niveau se fait par une source de tension constante, mais d'une manière qui permet de fournir une quantité de charges d'autant plus élevée que l'éclairement est plus faible;
- la figure 10 représente un diagramme temporel des variations de tension correspondant au mode de réalisation de la figure 9;
- la figure 11 représente un diagramme temporel de la succession des phases de commande des différentes lignes de la matrice.

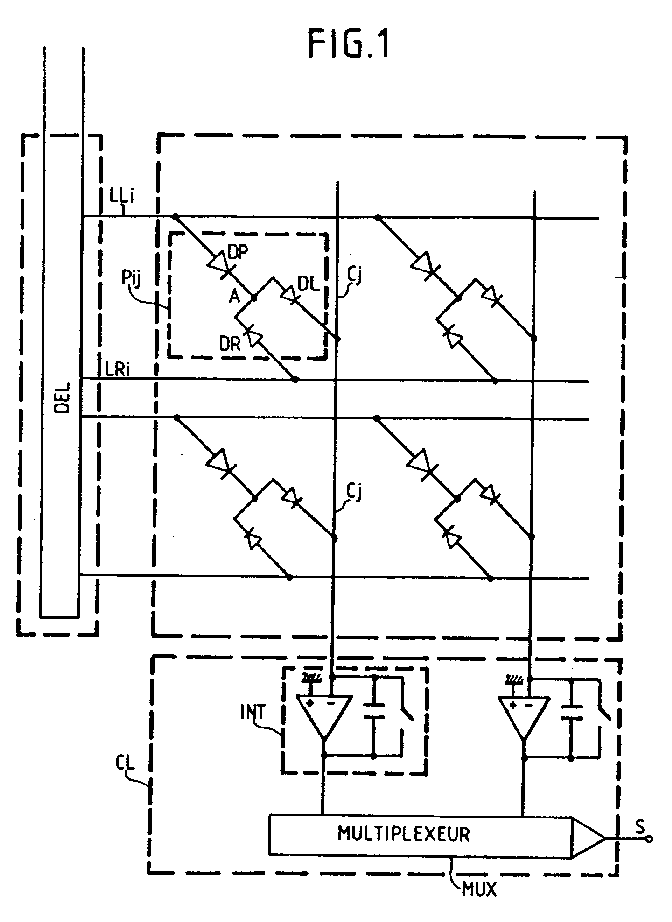

Sur la figure 1, on voit un schéma simplifié d'une matrice de points photosensibles selon un mode de réalisation de la présente invention.

La matrice comprend un réseau de lignes et de colonnes de points photosensibles Pij.

Chaque ligne comprend en fait deux conducteurs de ligne LLi et LRi auxquels sont raccordés les points photosensibles de cette ligne; le conducteur de ligne LLi sert à fournir une impulsion de tension de lecture des points de cette ligne; le conducteur de ligne LRi sert à fournir une impulsion de remise à niveau avant une nouvelle phase d'intégration. Les conducteurs de ligne sont connectés à un décodeur de ligne DEL apte à sélectionner une ligne déterminée dont on veut lire les points; le décodeur de ligne DEL autorise la transmission d'impulsions de lecture et de remise à niveau sur les conducteurs LLi et LRi, respectivement, de la ligne sélectionnée.

Chaque colonne comprend un conducteur de colonne Cj auquel sont raccordés les points photosensibles de cette colonne; le conducteur de colonne Cj est relié à un circuit CL de lecture des charges générées par le point photosensible Pij situé à l'intersection de cette colonne et de la ligne sélectionnée.

Dans un exemple de réalisation, le circuit de lecture comprend un intégrateur INT pour chacune des colonnes de points, et un multiplexeur MUX recevant les sorties des intégrateurs pour fournir sur sa sortie S successivement des signaux représentant l'éclairement des points successifs de la ligne désignée.

Dans d'autres cas, le circuit de lecture pourrait être un circuit à transfert de charges et le multiplexeur pourrait être un registe à décalage à transfert de charges.

Selon l'invention, chaque point photosensible Pij comprend trois diodes reliées à un noeud flottant commun A et désignées respectivement par
- DP (diode dont la caractéristique principale est d'être photosensible);
- DL (diode de lecture permettant le transfert de charges du noeud flottant A vers le conducteur de colonne Cj);
- DR (diode de remise à niveau permettant la remise à un niveau déterminé du potentiel du noeud A après une opération de lecture);

Dans le mode de réalisation de la figure 1, la diode photosensible DP est connectée entre le premier conducteur de ligne LLi et le noeud flottant A, la diode de lecture DL est connectée entre le conducteur de colonne et le noeud flottant, et la diode de remise à niveau est connectée entre le deuxième conducteur de ligne LRi et le noeud flottant.

Plus précisément, dans l'exemple de la figure 1, c'est la cathode de la diode photosensible DP, l'anode de la diode de lecture DL, et la cathode de la diode de remise à niveau qui sont connectées au noeud flottant; mais on peut prévoir de manière équivalente, à condition d'inverser les sens relatifs des potentiels mis en jeu sur les conducteurs de ligne et de colonne, une inversion des anodes et cathodes des trois diodes; dans ce cas, on aurait l'anode de la diode photosensible, la cathode de la diode de lecture, et l'anode de la diode de remise à niveau connectées au noeud flottant.

La diode DP est de surface relativement importante pour que sa sensibilité soit suffisante; les deux autres diodes sont plus petites et sont de préférence mises dans l'obscurité, surtout la diode de lecture DL qui risquerait, si elle était éclairée de retrancher des charges du signal utile stocké sur le noeud flottant.

La capacité de la colonne de points sera d'autant plus faible (ce qui est avantageux) que la capacité de la diode de lecture sera faible, ce qui incite à prendre pour DL une diode de petites dimensions.

### FONCTIONNEMENT DU SCHEMA DE LA FIGURE 1

Pour simplifier les explications, on supposera que la capacité des diodes DL et DR est très faible devant celle de la diode photosensible DP; s'il n'en était pas ainsi, les valeurs numériques de potentiels et de variations de potentiel indiqués au cours des explications seraient modifiées, mais le principe de fonctionnement resterait valable.

On négligera aussi les chutes de potentiel dans les diodes lorsqu'elles sont polarisées en direct, alors que ces chutes sont de l'ordre de 0,5 volt.

Enfin, on supposera que le circuit de lecture connecté aux colonnes maintient le potentiel de celles-ci à une valeur de référence nulle.

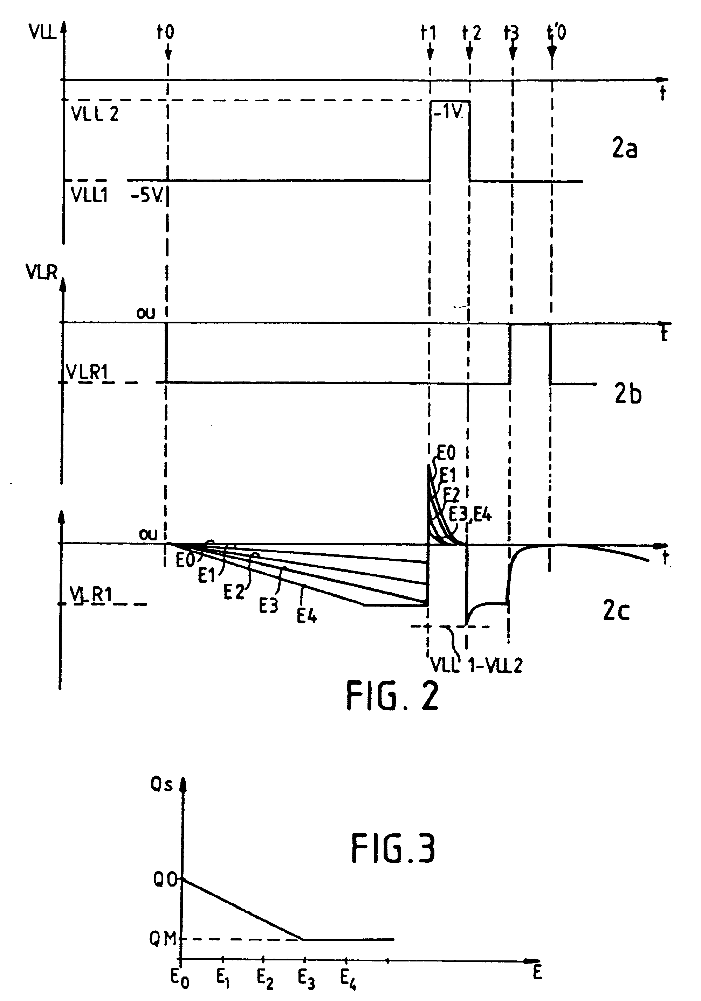

La figure 2 représente des diagrammes temporels permettant d'illustrer le fonctionnement.

Le cycle de fonctionnement périodique dure entre un instant t0 et un instant t'0.

Au départ, juste avant l'instant t0, l'état initial est le suivant (figure 2, diagramme 2a, 2b, 2c):
- le potentiel VLL sur le premier conducteur de ligne LLi a une valeur négative VLL1, par exemple -5 volt;
- le potentiel VLR sur le deuxième conducteur de ligne LRi a une valeur nulle;
- le potentiel VA sur le noeud A a une valeur nulle.

On verra que c'est bien la situation qui va exister à la fin du cycle de lecture qu'on va maintenant décrire.

Au temps t0, on applique sur le deuxième conducteur de ligne LRi de la ligne sélectionnée un potentiel négatif VLR1, qui est de préférence inférieur en valeur absolue à VLL1; il est par exemple de -3 volts.

Comme la capacité de la diode DR est très faible devant celle de la diode DP, le potentiel du noeud A ne varie presque pas sous l'effet de cette commutation de tension (il varie cependant négativement suffisamment pour bloquer la diode de lecture DL).

Du temps t0 jusqu'au temps t1, la photodiode DP éclairée engendre des charges (ici des électrons) qui viennent s'accumuler sur le noeud A, faisant baisser le potentiel de ce noeud en proportion de l'éclairement. Les charges ne peuvent s'évacuer par aucune des diodes car elles sont toutes polarisées en inverse (du moins tant que le potentiel du noeud A ne descend pas au dessous du potentiel de l'un des deux conducteurs LLi et LRi, c'est-à-dire ici au dessous de -3 volts).

Le diagramme de la figure 2c montre ce qui se passe pour divers niveaux d'éclairment:
- niveau E0, éclairement nul,
- niveau E1, éclairement faible,
- niveau E2, éclairement moyen,
- niveau E3, éclairement maximal lisible,
- niveau E4, éclairement trop fort: saturation.

L'éclairement maximal E3 est l'éclairement tel qu'à la fin de la période d'intégration de charges, au temps t1 où commence la lecture proprement dite, le potentiel du point A atteint le niveau négatif VLR1 ou le niveau VLL1 (en pratique VLR1 puisque VLR1 est moins négatif que VLL1).

Au delà de cet éclairement E3, la diode de remise à niveau DR passe en direct et le potentiel du noeud A ne peut plus descendre (saturation). Il faut d'ailleurs noter à ce propos que l'excès de charges engendrées est évacué vers un conducteur de ligne (LRi) et non pas vers un conducteur de colonne où il perturberait le signal des lignes qui pourraient être en cours de lecture à ce moment. L'effet d'antiéblouissement produit par la diode de remise à niveau s'exerce donc d'une manière particulièrement intéressante.

A l'instant t1, qui marque la fin du temps d'intégration, on applique sur le premier conducteur de ligne LLi une impulsion de lecture (figure 2a); cette impulsion fait passer brusquement le potentiel VLL de ce conducteur de la valeur VLL1 largement négative à une valeur VLL2 faiblement négative (par exemple -1 volt). Le potentiel du noeud flottant A monte alors brusquement (diagramme 2c) d'une valeur correspondant à l'augmentation de la tension VLL, c'est à dire d'une valeur (VLL2 - VLL1). Cette montée brusque se fait par couplage capacitif à travers la photodiode DP qui est polarisée en inverse et se comporte comme une capacité.

Si on s'arrange pour que l'amplitude (VLL2 - VLL1) de l'impulsion de lecture soit supérieure à la valeur absolue de la tension VLR1 appliquée au deuxième conducteur de ligne, on voit que le potentiel du noeud A deviendra toujours positif à l'instant t1 quel que soit le niveau d'éclairement pendant l'intervalle t0, t1 (diagramme 2c).

La diode de lecture devient donc systématiquement conductrice puisque le potentiel du conducteur de colonne est égal à zéro. De ce fait, les charges stockées sur le noeud flottant s'évacuent à travers la diode de lecture vers le conducteur de colonne et engendrent un signal dans le circuit de lecture CL.

A mesure de cette évacuation, le potentiel du noeud flottant A descend et revient à zéro; cette descente est rapide et doit être terminée à la fin de l'impulsion de lecture, c'est-à-dire au temps t2. Le diagramme 2c représente le retour à zéro du potentiel du noeud A en fonction du niveau d'éclairement qui avait été reçu par la photodiode DP.

Au temps t2 qui marque la fin de l'impulsion de lecture, le potentiel du premier conducteur de ligne revient à sa valeur de départ VLL1, entrainant sur le noeud A (redevenu flottant puisqu'aucune diode n'est polarisée en direct à ce moment) une chute brutale de potentiel d'une amplitude égale à VLL2 - VLL1 (diagramme 2c, temps t2).

La chute brutale du potentiel du noeud A de zéro à une valeur VLL2 - VLL1 rend la diode de remise à niveau DR momentanément conductrice, ce qui ramène le potentiel du noeud A à la valeur VLR1 du potentiel du deuxième conducteur de ligne LRi.

Au temps t3 commence la phase de remise à niveau du potentiel du noeud A. Cette remise à niveau est nécessaire pour revenir aux conditions de départ dans lesquelles le potentiel du noeud A était nul.

La remise à niveau est faite par une impulsion de remise à niveau appliquée au deuxième conducteur de ligne LRi dont le potentiel VLR1 n'a pas varié depuis le début du cycle. L'impulsion est une impulsion positive d'amplitude VLR1, c'est à dire qu'elle ramène à zéro le potentiel du conducteur de ligne. Cette impulsion commence au temps t3; elle se termine à l'instant t'0 de départ d'un nouveau cycle de lecture.

On peut remarquer ici que l'impulsion de remise à niveau peut commencer avant la fin de l'impulsion de lecture pourvu qu'elle ne commence pas avant que le potentiel du point A ne soit repassé d'une valeur positive à zéro et pourvu qu'elle se termine après l'impulsion de lecture.

L'impulsion de remise à niveau a pour effet de ramener à zéro le potentiel du noeud A puisque la diode de remise à niveau est alors polarisée en direct (diagramme 2c). Le potentiel du noeud A reste alors à zéro jusqu'à la fin de l'impulsion de remise à niveau, c'est-à-dire jusqu'au temps t'0 où débute un nouveau cycle d'intégration de charges.

La figure 3 représente un diagramme de valeur de la charge recueillie sur la colonne Cj pendant l'impulsion de lecture, en fonction de l'éclairement reçu pendant la période d'intégration t0,t1. Cette charge est proportionnelle à l'intégrale de la variation du potentiel du point A pendant l'impulsion de lecture; la variation est visible sur le diagramme 2c de la figure 2.

Sur la figure 3, on voit que le signal utile Qs est linéaire pour un éclairement variant entre l'éclairement nul E0 et l'éclairement maximal E3; au delà, il y a saturation et la charge lue est indépendante de l'éclairement.

Il est très intéressant de constater sur cette figure que la charge lue décroît avec l'éclairement; elle est maximale (Q0) pour un éclairement nul. Cela est très important car c'est généralement pour les faibles éclairements qu'on recueille des faibles charges qui sont plus difficiles à transférer (ou à transférer rapidement) que des charges plus importantes. Il est important aussi de constater que même pour l'éclairement maximal E3, la charge QM recueillie n'est pas nulle dès lors que la différence de potentiel VLL2 - VLL1 est supérieure en valeur absolue à VLR1. Par conséquent, on ne sera jamais dans la situation où une charge nulle doit être lue.

Le fonctionnement du cycle d'intégration de charges et lecture de ces charges a donc été complètement décrit pour une ligne de la matrice. Les différentes lignes reçoivent successivement chacune une impulsion de lecture suivie d'une impulsion de remise à niveau, et ces impulsions sont décalées dans le temps d'une ligne à l'autre pour qu'il n'y ait pas simultanément deux lignes adressées en lecture/remise à niveau.

On peut remarquer que la capacité de la colonne est sensiblement égale (en tout cas pas supérieure) à la somme des capacités des diodes de lecture DL des lignes non adressées. Cette capacité est bien inférieure à ce qu'elle était dans l'art antérieur (point photosensible utilisant une photodiode en série avec une capacité) car la capacité de la diode DL peut être nettement plus faible que celle de la photodiode et la capacité de l'art antérieur.

Enfin, on peut remarquer que la photodiode DP reste polarisée en inverse pendant tout le cycle d'intégration et lecture, ce qui évite son vieillissement prématuré et ce qui évite l'introduction d'un bruit important lors de la lecture.

### VARIANTE DE FONCTIONNEMENT

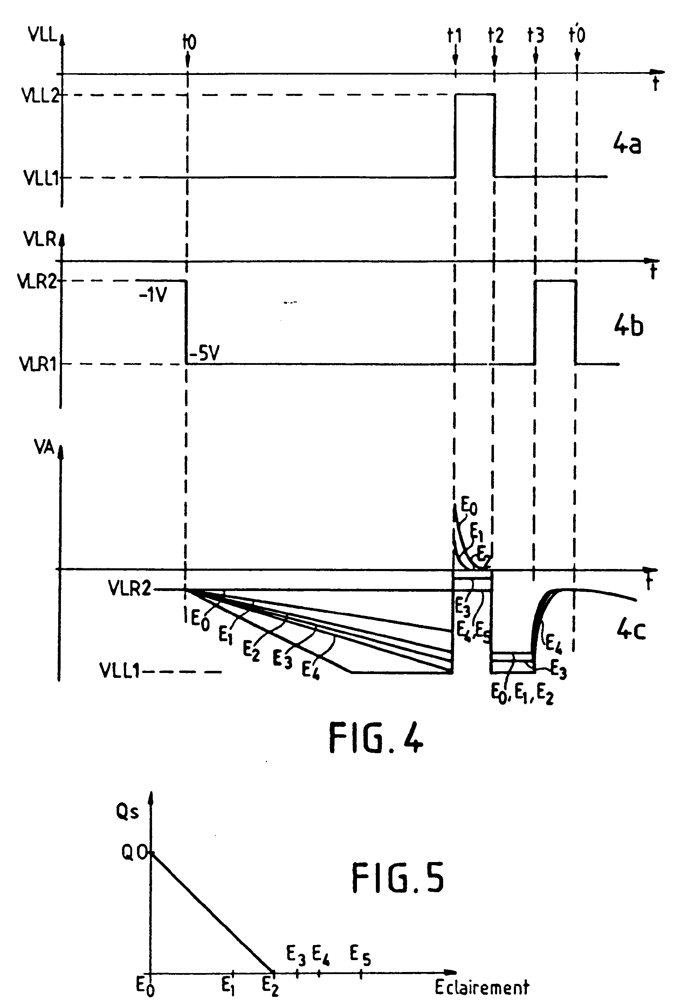

Dans une variante de réalisation, on modifie les potentiels de la manière représentée à la figure 4, c'est-à-dire que
- d'une part le potentiel le plus négatif VLR1 du deuxième conducteur de ligne LRi est égal au potentiel le plus négatif VLL1 du premier conducteur de ligne LLi,
- d'autre part, le potentiel le plus positif du deuxième conducteur (pendant l'impulsion de remise à niveau) n'est plus nul mais égal à une valeur VLR2 légèrement négative (par rapport au potentiel de colonne), de préférence égale au potentiel haut VLL2 de l'impulsion de lecture.

Il en résulte que les impulsions de lecture et de remise à niveau ont la même amplitude, et de plus elles ont le même niveau haut et le même niveau bas (voir diagrammes 4a et 4b de la figure 4).

On a représenté sur le diagramme 4c de la figure 4 les variations de potentiel du noeud A respectivement pour un éclairement nul E0, un éclairement moyen E1, un éclairement maximal mesurable E2, un éclairement plus important E3, et un éclairement élevé E4 pour lequel une fonction d'antiéblouissement entre en jeu.

Contrairement au cas de la figure 2, le potentiel du noeud A à l'instant t0 de démarrage du cycle d'intégration/lecture n'est pas nul mais égal à VLR2, valeur à laquelle il a été ramené par l'impulsion de remise à niveau précédente.

Pour les éclairement E0, E1, et E2, le fonctionnement est très semblable à celui qui a été expliqué à propos des figures 1 à 3, à l'exception du fait que pour l'éclairement E2, la charge transmise au conducteur de colonne Cj pendant l'impulsion de lecture est nulle: on ne bénéficie plus de la charge minimale QM visible à la figure 3.

Au delà de l'éclairement E2, l'impulsion de lecture ne fait plus passer au dessus de zéro le potentiel du noeud A et aucune charge ne peut plus se déverser sur la colonne Cj.

Le potentiel du noeud A reste donc pendant toute la durée de lecture à la valeur qu'il a atteinte à la fin de la période d'intégration, augmentée de la différence VLL2-VLL1.

A partir d'un niveau d'éclairement E4 correpondant à un potentiel négatif égal à VLL1 sur le noeud A, la fonction d'antiéblouissement entre en jeu, les charges produites en excès se déversant dans les conducteurs de ligne.

L'impulsion de lecture consiste à faire monter brusquement d'une valeur VLL2 - VLL1 le potentiel du noeud flottant A; ce potentiel devient supérieur à zéro si l'éclairement est compris entre E0 et E2, ce qui rend conductrice la diode de lecture DL et qui transfère des charges du noeud A vers la colonne Cj.

La fin de l'impulsion de lecture ramène le potentiel du noeud A à une valeur VLL1 - VLR2 si l'éclairement était normal (entre E0 et E2) et à une valeur variable entre VLL1 et VLL1-VLL2 pour des éclairements supérieurs. De toutes façons, ce potentiel est ramené à sa valeur de départ VLR2 par l'application de l'impulsion de remise à niveau sur le deuxième conducteur de ligne.

L'impulsion de remise à niveau rend conductrice la diode de remise à niveau DR et ramène le potentiel du noeud flottant à la valeur de potentiel VLR2 présente sur le conducteur de ligne LRi pendant cette impulsion.

Le cycle d'intégration suivant commence à l'instant t0 marquant la fin de l'impulsion de remise à niveau.

La figure 5 représente le diagramme de la charge lue sur la colonne Cj, c'est-à-dire l'intégrale de la variation de potentiel du noeud A pendant la durée de l'impulsion de lecture, en fonction de l'éclairement. La variation est linéaire, à pente négative, et la charge lue est maximale pour un éclairement nul. Il n'y a plus de charge minimale lue.

Le choix des potentiels VLL1, VLL2, VLR1, VLR2 qui a été fait dans le cas de la figure 3 présente un intérêt tout particulier du fait que l'impulsion de lecture est rigoureusement identique à une impulsion de remise à niveau, avec seulement un décalage dans le temps entre les deux.

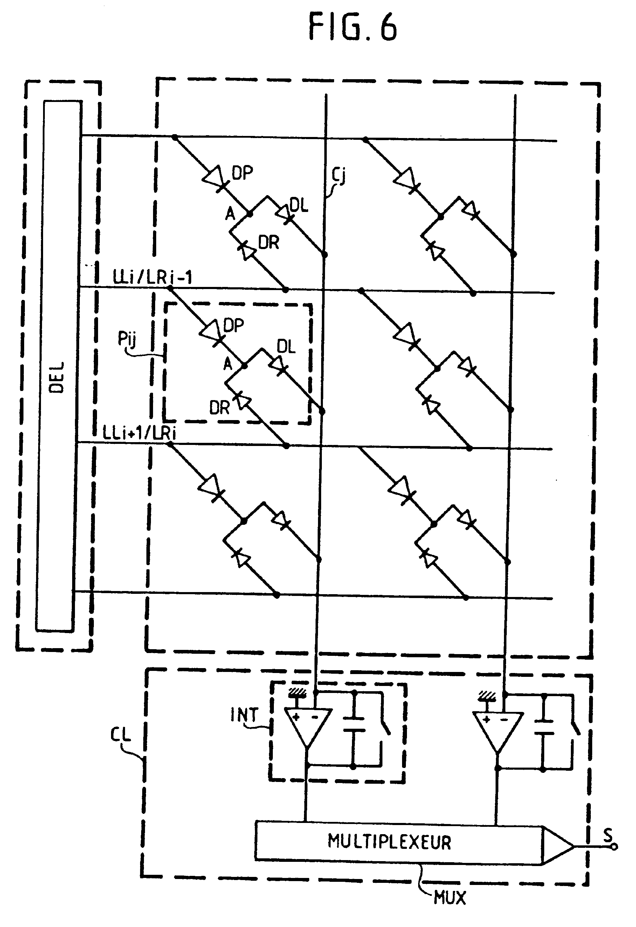

La figure 6 représente un mode de réalisation qui met à profit cette particularité.

Sur la figure 6, on a regroupé en un seul conducteur de ligne le deuxième conducteur de ligne LRi de la ligne considérée et le premier conducteur de ligne LLi+1 de la ligne suivante. L'impulsion de remise à niveau de la première ligne sert d'impulsion de lecture pour la ligne suivante, et ainsi de suite.

Le circuit fonctionne exactement selon les explications données à propos de la figure 3. Comme l'impulsion de remise à niveau n'injecte aucune charge sur la colonne Cj mais seulement sur une ligne, il n'y a aucun inconvénient à ce que cette impulsion serve d'impulsion de lecture pour une autre ligne de points.

Le décodeur DEL qui sert à l'adressage des lignes devra appliquer séquentiellement à chaque ligne une impulsion jouant deux rôles.

Sur le schéma de la figure 6, le conducteur de ligne Li est partagé entre deux lignes adjacentes de points photosensibles, et les impulsions appliquées sur les lignes successives se succèdent dans l'ordre des lignes.

On peut noter que d'autres solutions sont possibles dans lesquels le conducteur de ligne issu du décodeur de ligne DEL est partagé entre deux lignes non adjacentes, auquel cas ce conducteur doit être dédoublé (mais il reçoit un signal unique constitué par une impulsion de lecture/remise à niveau). Cette disposition présente un intérêt pour des matrices dans lesquelles on veut pouvoir faire d'une part une sommation des signaux de plusieurs lignes et d'autre part un balayage entrelacé (balayage d'une ligne sur deux dans une première demi-trame et des autres dans la deuxième demi-trame). Cette disposition est utilisable par exemple si on veut lire des groupes de deux lignes adjacentes à la fois (en recueillant sur la colonne la somme des charges correspondant à ces deux lignes) ; et d'ailleurs, cette lecture de deux ou plusieurs lignes adjacentes à la fois peut être faite en balayage entrelacé: on lira un groupe de deux lignes, on sautera le deuxième, on lira le troisième etc., pendant une première demi-trame ; puis on sautera le premier groupe, on lira le deuxième, on sautera le troisième, etc., pendant la 2ème demi-trame. On utilise alors un conducteur de ligne partagé entre la première ligne et la cinquième, un autre partagé entre la deuxième et la sixième etc.

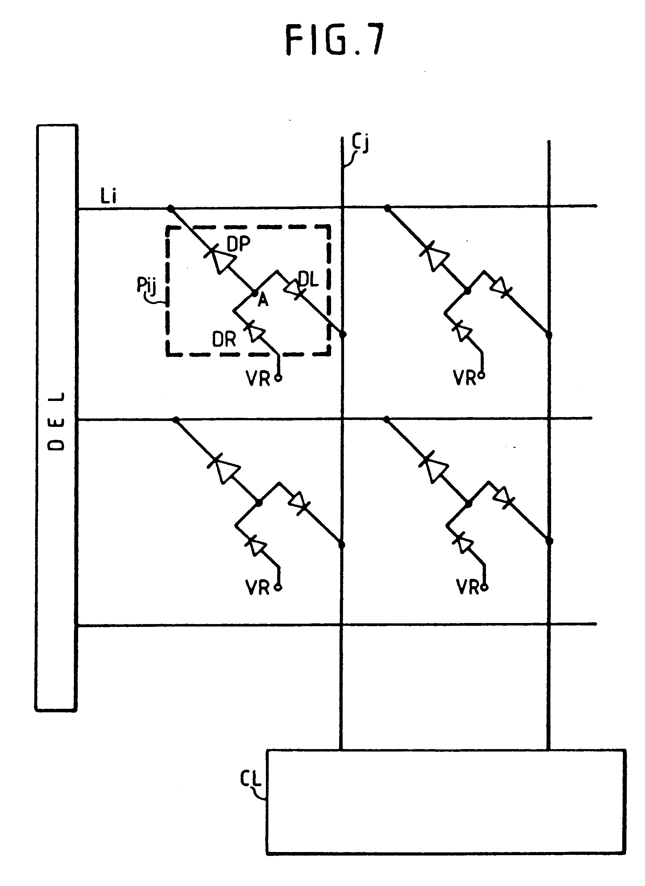

On va maintenant décrire une autre réalisation, particulièrement intéressante de l'invention. Cette réalisation est décrite en référence à la figure 7.

La figure 7 se distingue de la figure 1 par deux points principaux:
1) La diode photosensible DP est retournée par rapport aux autres; si l'anode de la diode de lecture et la cathode de la diode de remise à niveau sont toujours connectées au noeud flottant A comme aux figures 1 et 6, alors c'est maintenant l'anode de la photodiode DP et non plus sa cathode qui est reliée au noeud A; inversement, si la cathode de la diode de lecture et l'anode de la diode de remise à niveau sont reliées au noeud commun A, alors, le mode de réalisation de la figure 7 nécessite que la cathode de la diode photosensible DP soit reliée au noeud commun A.
2) La source de tension de remise à niveau n'est plus un conducteur de ligne (LRi à la figure 1) qui transmet une impulsion de remise à niveau périodiquement, à une ligne de points photosensibles à la fois, après l'impulsion de lecture transmise à la même ligne de points photosensibles; mais la source de tension de remise à niveau est tout simplement une source de tension fixe VR et tous les points photosensibles sont reliés à la même source de tension.

On voit le bénéfice que l'on peut tirer de cette disposition, puisqu'il n'y a plus besoin d'adresser chaque ligne de points photosensibles par deux conducteurs tels que LLi et LRi ou d'adresser chaque ligne par un seul conducteur (comme à la figure 6) mais avec des limitations dues au fait que l'on est obligé de prévoir exactement les mêmes caractéristiques pour l'impulsion de lecture et l'impulsion de remise à niveau.

La structure du point photosensible de la figure 7 se résume donc très simplement à trois diodes reliées au noeud commun A, avec :
- cathode de la diode photosensible DP reliée à un conducteur de ligne Li lui-même relié à une sortie d'un décodeur de ligne; le décodeur permet de fournir périodiquement une impulsion de lecture à une ligne désignée de la matrice;
- cathode de la diode de lecture DL reliée comme auparavant au conducteur de colonne Cj sur lequel on veut recueillir le signal engendré par le point photosensible;
- anode de la diode de remise à niveau DR reliée à une source de tension de référence VR.

Les diodes de lecture DL et de remise à niveau DR sont de préférence petites et autant que possible placées dans l'obscurité.

### FONCTIONNEMENT DE LA FIGURE 7

Compte tenu de la petite taille des diodes DL et DR par rapport à la diode photosensible DP, on supposera pour simplifier l'explication, que les capacités de ces diodes sont faibles devant celle de la diode DP. Cela veut dire que toute variation de tension appliquée brutalement au conducteur de ligne Li se retrouve immédiatement et pratiquement intégralement sur le point A.

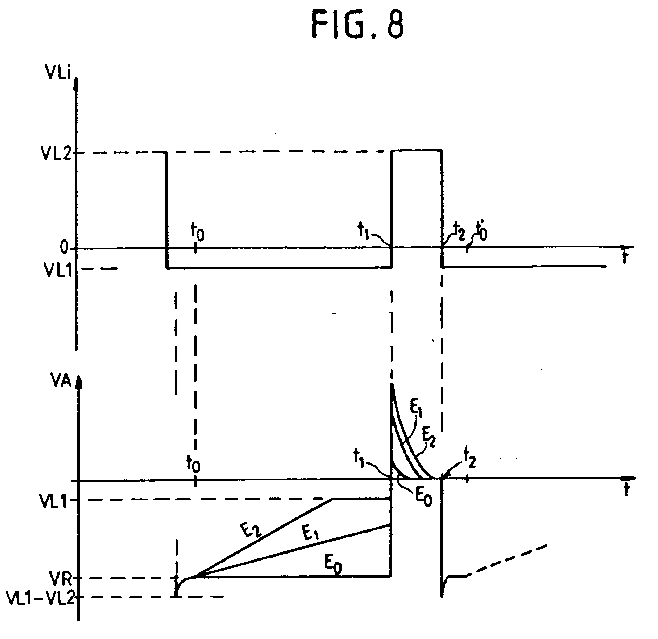

La figure 8 représente un diagramme temporel des variations de potentiel du point A d'abord entre un instant t0 de démarrage et un instant t'0 de fin d'un cycle d'intégration/lecture de charges. La période d'intégration de charges va de l'instant t0 à un instant t1 où est appliqué une impulsion de lecture sur le conducteur de ligne Li. La période de lecture dure le temps de l'impulsion de lecture, c'est-à-dire jusqu'à un instant t2. Entre l'instant t2 et l'instant t'0 de démarrage d'un nouveau cycle s'écoule un temps court de remise à niveau, mais cette remise à niveau est automatique; elle ne résulte pas d'un signal de commande qui devrait être engendré entre le temps t2 et le temps t'0 comme aux figures 1 à 6.

On suppose au départ que le potentiel VA du noeud A est égal à la tension de référence VR, que l'on choisit aussi négative que possible par rapport à la tension de référence zéro (qui est la tension à laquelle le circuit de lecture CL maintient la colonne); par exemple, la tension VR est de - 5 volts. On verra que c'est bien à cet état de départ VA = VR que l'on revient à la fin du cycle.

Entre les instants t0 et t1, le potentiel du conducteur de ligne est maintenu à une valeur faiblement négative VL1 (par exemple -1 volt). Par conséquent, à l'instant t0, la diode photosensible DP est polarisée en inverse, et la diode de lecture DL aussi; la diode de remise à niveau a une tension nulle à ses bornes. Le noeud commun A est donc isolé de tout côtés et son potentiel est flottant. L'éclairement de la photodiode engendre des charges (ici des trous) qui viennent se stocker sur ce noeud flottant et qui font monter le potentiel du noeud A. La montée du potentiel est plus ou moins rapide selon le niveau d'éclairement et elle est représentée à la figure 8 dans trois cas d'éclairement qui sont
- un éclairement nul E0 qui ne fait pas varier le potentiel du noeud A;
- un éclairement moyen E1;
- et un éclairement trop fort E2 qui sature le point photosensible.

Tant que le potentiel du noeud A n'atteint pas le potentiel faiblement négatif VL1 du conducteur de ligne, toutes les diodes restent bloquées et le potentiel du noeud A peut effectivement croître en proportion de l'éclairement.

Il est possible cependant que, par suite d'un éclairement trop fort, le potentiel du noeud A atteigne le potentiel VL1 du conducteur de ligne pendant la période d'intégration de charges, c'est-à-dire avant le début de l'impulsion de lecture (instant t2).

Dans ce cas, la diode photosensible DP devient conductrice, ce qui a pour conséquences:
1) que le potentiel du noeud A cesse de croître; on est donc sûr qu'au moment de la lecture on enverra sur la colonne une quantité de charges bien déterminée qui correspond au seuil de saturation du dispositif;
2) que les charges qui continuent à arriver par suite de l'éclairement sont dirigées vers le conducteur de ligne et non pas vers le conducteur de colonne où elles risqueraient de perturber le signal en provenance d'une autre ligne qui serait lue à ce moment.

A l'instant t1 arrive l'impulsion de lecture sur le conducteur de ligne Li. Cette impulsion de lecture consiste à faire passer le potentiel du conducteur de ligne de sa valeur faiblement négative VL1 à une valeur fortement positive VL2.

L'excursion de tension VL2 - VL1 peut être de 6 volts par exemple.

Comme la photodiode est polarisée en inverse et que sa capacité est largement supérieure à celle des autres diodes, l'augmentation brusque de tension est immédiatement et intégralement transmise au noeud A. C'est vrai aussi si on a saturé le dispositif car alors la photodiode est en direct et permet aussi la transmission de l'augmentation de tension.

Le potentiel du point A s'accroît brusquement d' une valeur VL2 - VL1.

L'excursion de tension VL2 - VL1 est choisie de préférence de manière que même en cas d'éclairement nul (VA = VR à l'instant t1), le potentiel du point A devienne positif; autrement dit, on prévoit de préférence que VL2 - VL1 est supérieur à la valeur absolue de la tension de remise à niveau VR (prise par rapport à la tension de référence de colonne). Ce choix a l'avantage de permettre la transmission d'une charge d'entrainement non nulle même pour un éclairement nul, ce qui facilite la lecture des faibles éclairements.

Dès que la tension du point A devient positive, la diode de lecture devient polarisée en direct et les charges stockées au point A sont évacuées sur le conducteur de colonne Cj qui les transmet au circuit de lecture CL.

La figure 8 représente la variation du potentiel du noeud A pendant l'impulsion de lecture (t1 à t2) pour les différents niveaux d'éclairement envisagés (nul, moyen, de saturation).

L'impulsion de lecture doit avoir une durée suffisante pour permettre l'évacuation de toutes les charges stockées sur le noeud A, même pour le cas d'un éclairement de saturation.

A la fin de l'impulsion de lecture, la diode de lecture se trouve dans un état bloqué (tension nulle à ses bornes);le potentiel du conducteur de ligne repasse brusquement à sa valeur faiblement négative VL1. La diminution brutale de tension se retransmet intégralement au noeud A qui descend à une tension VL1 - VL2.

La diode de remise à niveau passe alors en polarisation directe puisqu'on a supposé que VL2 - VL1 était plus grand que la tension de référence VR. Le potentiel du noeud A remonte alors à la valeur VR.

Un nouveau cycle d'intégration/lecture peut recommencer à l'instant t'0.

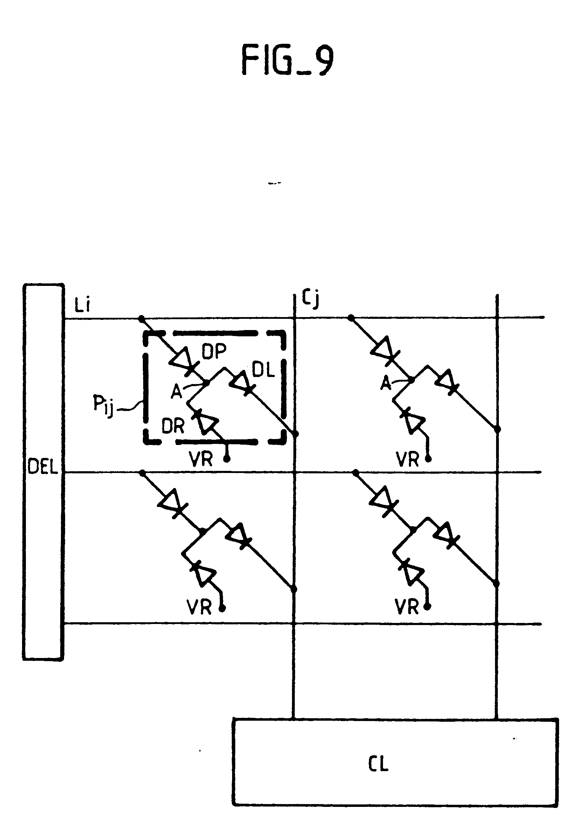

La figure 9 représente un autre mode de réalisation de l'invention. Le ppoint photosensible est constitué exactement comme celui décrit à propos de la figure 1, mais le conducteur de remise à niveau (auquel est reliée la diode DR de remise à niveau) n'est plus un conducteur commandé par un dispositif d'adressage de ligne; c'est au contraire, comme à la figure 7, un conducteur commun à tout le plan photosensible, et ce conducteur est porté en permanence à un potentiel fixe VR.

Les sens des trois diodes DP, DL, DR pourraient être tous inversés simultanément pourvu qu'on change aussi les sens des potentiels.

La structure du point photosensible de la figure 9 se résume donc très simplement à trois diodes reliées au noeud commun A, avec :
- anode de la diode photosensible DP reliée à un conducteur de ligne Li lui-même relié à une sortie d'un décodeur de ligne; le décodeur permet comme on le verra de fournir périodiquement à une ligne désignée de la matrice un signal en créneau à trois niveaux de tension;
- anoode de la diode de lecture DL reliée comme auparavant au conducteur de colonne Cj sur lequel on veut recueillir le signal engendré par le point photosensible;
- cathode de la diode de remise à niveau DR reliée à une source de tension de référence VR.

Les diodes de lecture DL et de remise à niveau DR sont là encore de préférence petites et autant que possible placées dans l'obscurité.

### FONCTIONNEMENT DU SCHEMA DE LA FIGURE 9

Compte tenu de la petite taille des diodes DL et DR par rapport à la diode photosensible DP, on supposera pour simplifier l'explication, que les capacités de ces diodes sont faibles devant celle de la diode DP. Cela veut dire que toute variation de tension appliquée brutalement au conducteur de ligne Li se retrouve immédiatement et pratiquement intégralement sur le point A.

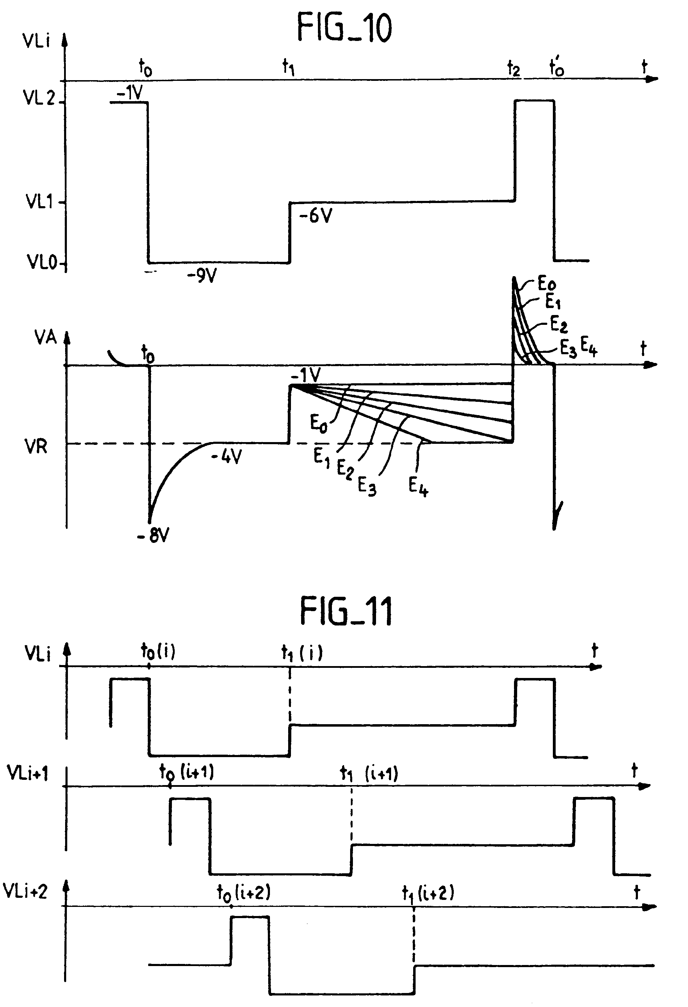

La figure 10 représente un diagramme temporel des variations de potentiel du point A d'abord entre un instant t0 de démarrage et un instant t'0 de fin d'un cycle d'intégration/lecture de charges/remise à niveau.

La tension de remise à niveau VR est négative, pour les polarités de diodes représentées, et en supposant que la référence de potentiel nul est le potentiel des conducteurs de colonne. Par exemple, VR = -4 volts.

Le cycle périodique de fonctionnement commence par une première phase de remise à niveau qui va de l'instant t0 à un instant t1. Pendant cette phase, le potentiel appliqué au conducteur de ligne Li a une première valeur VL0, plus négative que la tension VR de la source de remise à niveau, par exemple -9 volts pour une tension VR de -4 volts.

La deuxième phase est une phase d'intégration de charges pendant laquelle la photodiode éclairée accumule des charges (ici des électrons) sur le noeud flottant. Pendant cette phase, de l'instant t1 à l'instant t2, le potentiel du conducteur de ligne est porté à une valeur VL1 nettement supérieure à la tension VR mais quand-même négative. La différence VL1 - VL0 limitera la dynamique de mesure des charges, et il faut donc que cette différence soit suffisante. Par exemple, VL1 = -6 volts.

La troisième phase est une phase de lecture des charges stockées sur le noeud A. Pour cette phase, qui dure de l'instant t2 à l'instant t'0 de démarrage d'un nouveau cycle, le potentiel du conducteur de ligne Li est porté à une troisième valeur VL2 qui est toujours négative, mais qui est aussi proche que possible de zéro. Pratiquement, on préfère que la différence VL2 - VL1 soit supérieure à la valeur absolue de VR. Ici, on choisit VL1 = -1 volt.

On suppose au départ que le potentiel VA du noeud A est nul. On verra que c'est bien à cet état de départ VA = 0 que l'on revient à la fin du cycle.

A l'instant t0 le potentiel du conducteur de ligne Li descend brusquement de la valeur VL2 à la valeur VL0. La variation de potentiel est donc de VL0 - VL2. Le potentiel du noeud A descend immédiatement d'autant (par couplage capacitif) et le potentiel du noeud A devient égal à VL0 - VL2.

Mais comme cette valeur est plus négative que la tension VR de remise à niveau, la diode DR devient conductrice et ramène à VR le potentiel du noeud A. C'est la phase de remise à niveau.

A l'instant t1, le potentiel du conducteur de ligne Li monte d'une valeur VL1 - VL0. Le potentiel du noeud A monte d'autant car d'une part aucune des trois diodes n'est polarisée en direct et d'autre part la capacité de la photodiode (par laquelle arrive l'impulsion de tension) est beaucoup plus forte que celle des autres diodes. Le potentiel du noeud A passe à la valeur VR + VL1 - VL0, dont on a précisé qu'elle était négative. La phase d'intégration de charges commence alors; les charges provenant de l'éclairement s'accumulent sur le noeud A et font baisser le potentiel de ce noeud. Il y a saturation si l'éclairement est suffisamment intense pour que le potentiel du noeud A descende au dessous de VR. La diode de remise à niveau DR empêche en effet le potentiel de descendre au dessous de VR.

A l'instant t2 qui marque la fin de la phase d'intégration, le potentiel du noeud A a une valeur comprise entre :
VR + VL1 - VL0 si l'éclairement était nul (E0)
et
VR si l'éclairement est supérieur (E4) ou égal (E3) à l'éclairement de saturation.

Le potentiel du conducteur de ligne Li passe alors à la valeur VL2. La variation de potentiel d'amplitude VL2 - VL1 est transmise au noeud A par couplage capacitif à travers la photodiode DP. Le potentiel du noeud A s'accroît d'une valeur correspondante de sorte qu'il devient positif et rend la diode de lecture DL conductrice. Les charges stockées au point A sont évacuées sur le conducteur de colonne Cj qui les transmet au circuit de lecture CL.

L'excursion de tension VL2 - VL1 est choisie de préférence de manière que même en cas d'éclairement nul (VA = VR + VL1 -VL0 à l'instant t2), le potentiel du point A devienne positif; autrement dit, on prévoit de préférence que VL2 - VL1 est supérieur à la valeur absolue de la tension de remise à niveau VR (prise par rapport à la tension de référence de colonne). Ce choix a l'avantage de permettre la transmission d'une charge d'entrainement non nulle même pour un éclairement maximal, ce qui facilite la lecture des forts éclairements. Quant à la lecture des faibles éclairements elle est très facile puisqu'alors la charge à transmettre sur le conducteur de colonne est maximale.

La variation de la quantité de charges évacuée pendant l'impulsion de lecture (t2 à t'0) pour les différents niveaux d'éclairement envisagés (nul, moyen, de saturation) est exactement la même qu'à la figure 3.

L'impulsion de lecture doit avoir une durée suffisante pour permettre l'évacuation de toutes les charges stockées sur le noeud A, même pour le cas d'un éclairement nul.

A la fin de l'impulsion de lecture, la diode de lecture se trouve dans un état bloqué (tension nulle à ses bornes);le potentiel du conducteur de ligne repasse brusquement à sa valeur fortement négative VL0. La diminution brutale de tension se retransmet intégralement au noeud A qui descend à une tension VL0 - VL2, et un nouveau cycle commence.

La figure 11 montre comment les cycles de remise à niveau/intégration/lecture doivent être décalés dans le temps les uns par rapport aux autres.

Les impulsions de lecture sont décalées pour ne pas se recouvrir mutuellement, mais il n'est pas nécessaire d'attendre pour commencer une impulsion de lecture d'une ligne que la phase de remise à niveau de la ligne précédente soit terminée.

## Revendications

1. Matrice de points photosensibles comportant un réseau de points photosensibles (Pij) agencés en lignes (au moins une ligne) et en colonnes (au moins une colonne), chaque point photosensible étant situé au carrefour d'une ligne et d'une colonne et étant apte à intégrer, entre deux phases de lecture successives, des charges électriques résultant de l'éclairement de ce point, caractérisé en ce que chaque point photosensible comprend trois diodes (DP, DL, DR) reliées à un noeud commun flottant (A), une première diode (DP) dite diode photosensible étant reliée entre un conducteur de ligne (LLi) et le noeud flottant (A) pour engendrer lorsqu'elle est éclairée des charges électriques sur le noeud flottant, une deuxième diode (DL), dite diode de lecture, reliée entre le noeud flottant et un conducteur de colonne (Cj) pour permettre un transfert entre ce conducteur de colonne et le noeud flottant d'une quantité de charges correspondant à la quantité de charges générées par l'éclairement entre deux phases de lecture successives du point, et une troisième diode (DR), dite diode de remise à niveau, connectée entre le noeud flottant et un conducteur relié à une source de tension de remise à niveau, pour rétablir à une valeur choisie le potentiel du noeud flottant après ledit transfert de charges.

2. Matrice photosensible selon la revendication 1, caractérisée en ce que la source de tension de remise à niveau est une source de tension fixe (VR).

3. Matrice selon la revendication 2, caractérisée en ce que l'anode de la diode photosensible, l'anode de la diode de lecture, et la cathode de la diode de remise à niveau sont reliées au noeud commun, ou inversement; la cathode de la diode photosensible, la cathode de la diode de lecture et l'anode de la diode de remise à niveau sont reliées au noeud commun.

4. Matrice selon la revendication 2, caractérisée en ce qu'il est prévu un moyen pour appliquer sur le conducteur de ligne une impulsion de lecture ayant une amplitude qui, en valeur absolue, est supérieure à la valeur absolue de la différence de potentiel entre la source de tension de référence et un potentiel de référence auquel est maintenu le conducteur de colonne.

5. Matrice selon la revendication 1, caractérisée en ce que la cathode de la diode photosensible, l'anode de la diode de lecture, et la cathode de la diode de remise à niveau sont connectées au noeud flottant, ou inversement que l'anode de la diode photosensible, la cathode de la diode de lecture, et l'anode de la diode de remise à niveau sont connectées au noeud flottant.

6. Matrice selon la revendication 5, caractérisée en ce que la source de tension de remise à niveau est reliée à un autre conducteur de ligne (LRi), et en ce qu'il est prévu un moyen (DEL) pour appliquer sur le premier conducteur de ligne mentionné (LLi) une impulsion de lecture à la fin d'une période d'intégration de charges, et sur l'autre conducteur de ligne une impulsion de tension de remise à niveau suivant l'impulsion de lecture.

7. Matrice selon la revendication 6, caractérisée en ce que l'impulsion de lecture a une amplitude plus grande que l'impulsion de remise à niveau.

8. Matrice selon la revendication 6, caractérisée en ce que l'impulsion de lecture et l'impulsion de remise à niveau ont la même amplitude et les mêmes niveaux de potentiel haut et bas.

9. Matrice selon la revendication 8, caractérisée en ce que l'autre conducteur de ligne (LRi), relié à la diode de remise à niveau d'un point photosensible d'une ligne déterminée, est le premier conducteur de ligne (LLi+1) relié à la diode photosensible d'un point photosensible d'une autre ligne de la matrice.

10. Matrice selon l'une des revendications 1 à 9, caractérisé en ce qu'il est prévu un moyen pour appliquer sur le conducteur de ligne une impulsion de tension de lecture d'un premier signe par rapport à un potentiel de référence appliqué au conducteur de colonne pendant une phase d'intégration de charges, et simultanément avec l'impulsion de lecture, une impulsion de tension de sélection du signe opposé appliquée à un conducteur de colonne spécifié relié au point photosensible considéré, les autres conducteurs de colonne étant maintenus au potentiel de référence pendant cette impulsion de sélection.

11. Matrice selon la revendication 2, caractérisée en ce que la cathode de la diode photosensible, l'anode de la diode de lecture et la cathode de la diode de remise à niveau sont reliées au noeud commun, ou réciproquement que l'anode de la diode photosensible, la cathode de la diode de lecture et l'anode de la diode de remise à niveau sont reliées au noeud commun, et en ce qu'il est prévu un moyen pour appliquer sur le conducteur de ligne un cycle de variation de potentiel comprenant une première phase d'intégration de charges dans laquelle le potentiel du conducteur de ligne est à un premier niveau (VL1), une deuxième phase de lecture dans lequel le potentiel du conducteur de ligne est à un deuxième niveau (VL2), et une troisième phase de remise à niveau dans lequel le potentiel du conducteur de ligne est à un troisième niveau (VL0).

12. Matrice selon la revendication 11, caractérisée en ce que la différence de potentiel entre les premier et troisième niveaux est en valeur absolue inférieure à la différence de potentiel entre la source de tension de remise à niveau et un potentiel de référence des conducteurs de colonne.

13. Matrice selon la revendication 12, caractérisée en ce que la différence de potentiel entre les deuxième et premier niveaux est supérieure en valeur absolue à la différence de potentiel entre la source de tension de remise à niveau et un potentiel de référence des conducteurs de colonne.

## Patentansprüche

1. Matrix von lichtempfindlichen Punkten mit einem Netz von in Zeilen (mindestens 1 Zeile) und Spalten (mindestens 1 Spalte) angeordneten lichtempfindlichen Punkten (Pij), wobei jeder lichtempfindliche Punkt am Schnittpunkt einer Zeile und einer Spalte liegt und zwischen zwei aufeinanderfolgenden Lesephasen elektrische Ladungen aufgrund einer Beleuchtung dieses Punktes integrieren kann, dadurch gekennzeichnet, daß jeder lichtempfindliche Punkt drei Dioden (DP, DL, DR) enthält, die an einen gemeinsamen Knoten (A) mit undefiniertem Potential angeschlossen sind, wobei eine erste Diode (DP), lichtempfindliche Diode genannt, zwischen einen Zeilenleiter (LLi) und den Knoten (A) eingefügt ist, um elektrische Ladungen auf den Knoten bei einer Beleuchtung zu erzeugen, eine zweite Diode (DL), Lesediode genannt, zwischen den Knoten und einen Spaltenleiter (Cj) eingefügt ist, um eine Übertragung einer Ladungsmenge entsprechend der durch die Beleuchtung zwischen zwei aufeinanderfolgenden Lesephasen des Punktes erzeugten Ladungsmenge zwischen diesem Spaltenleiter und dem Knoten zu erlauben, und eine dritte Diode (DR), Potentialrückstelldiode genannt, zwischen den Knoten und einen an eine Potentialrückstellspannungsquelle angeschlossenen Leiter eingefügt ist, um das Potential des Knoten mit undefiniertem Potential nach jedem Ladungstransfer auf einen gewählten Wert zurückzusetzen.

2. Lichtempfindliche Matrix nach Anspruch 1, dadurch gekennzeichnet, daß die Spannungsquelle für die Potentialrücksetzung eine Quelle mit fester Spannung (VR) ist.

3. Matrix nach Anspruch 2, dadurch gekennzeichnet, daß die Anode der lichtempfindlichen Diode, die Anode der Lesediode und die Kathode der Potentialrückstelldiode mit dem gemeinsamen Knoten verbunden sind oder daß umgekehrt die Kathode der lichtempfindlichen Diode, die Kathode der Lesediode und die Anode der Potentialrückstelldiode mit dem gemeinsamen Knoten verbunden sind.

4. Matrix nach Anspruch 2, dadurch gekennzeichnet, daß ein Mittel vorgesehen ist, um an den Zeilenleiter einen Leseimpuls mit einer Amplitude anzulegen, die absolut gesehen größer als der Absolutwert der Potentialdifferenz zwischen der Bezugsspannungsquelle und einem Bezugspotential ist, auf dem der Spaltenleiter gehalten wird.

5. Matrix nach Anspruch 1, dadurch gekennzeichnet, daß die Kathode der lichtempfindlichen Diode, die Anode der Lesediode und die Kathode der Potentialrückstelldiode mit dem Knoten verbunden sind oder daß umgekehrt die Anode der lichtempfindlichen Diode, die Kathode der Lesediode und die Anode der Potentialrückstelldiode mit dem Knoten verbunden sind.

6. Matrix nach Anspruch 5 dadurch gekennzeichnet, daß die Spannungsquelle für die Potentialrückstellung an einen anderen Zeilenleiter (LRi) angeschlossen ist und daß ein Mittel (DEL) vorgesehen ist, um an dem erwähnten ersten Zeilenleiter (LLi) einen Leseimpuls am Ende einer Ladungsintegrationsphase sowie an den anderen Zeilenleiter einen Spannungsimpuls zur Potentialrückstellung gemäß dem Leseimpuls anzulegen.

7. Matrix nach Anspruch 6, dadurch gekennzeichnet, daß der Leseimpuls eine größere Amplitude als der Potentialrückstellimpuls besitzt.

8. Matrix nach Anspruch 6, dadurch gekennzeichnet, daß der Leseimpuls und der Potentialrückstellimpuls die gleiche Amplitude und die gleichen hohen und niedrigen Potentialpegel besitzen.

9. Matrix nach Anspruch 8, dadurch gekennzeichnet, daß der andere Zeilenleiter (LRi), der an die Potentialrückstelldiode eines lichtempfindlichen Punkts einer bestimmten Zeile angeschlossen ist, der erste Zeilenleiter (LLi + 1) einer anderen Zeile der Matrix ist und an die lichtempfindliche Diode eines lichtempfindlichen Punkts dieser Zeile angeschlossen ist.

10. Matrix nach einem der Ansprüche 1 bis 9, dadurch gekennzeichnet, daß ein Mittel vorgesehen ist, um während einer Ladungsintegrationsphase an den Zeilenleiter einen Lesespannungsimpuls mit einem ersten Vorzeichen bezüglich eines an den Spaltenleiter angelegten Bezugspotentials und gleichzeitig mit dem Leseimpuls einen Auswahlspannungsimpuls mit umgekehrten Vorzeichen an einen bestimmten Spaltenleiter anzulegen, der mit dem betrachteten lichtempfindlichen Punkt verbunden ist, während die anderen Spaltenleiter auf Bezugspotential während dieses Auswahlimpulses gehalten werden.

11. Matrix nach Anspruch 2, dadurch gekennzeichnet, daß die Kathode der lichtempfindlichen Diode, die Anode der Lesediode und die Kathode der Potentialrückstelldiode mit dem gemeinsamen Knoten verbunden sind oder daß umgekehrt die Anode der lichtempfindlichen Diode, die Kathode der Lesediode und die Anode der Potentialrückstelldiode mit dem gemeinsamen Knoten verbunden sind, und daß ein Mittel vorgesehen ist, um an den Zeilenleiter ein zyklisch variables Potential anzulegen, nämlich in einer ersten Ladungsintegrationsphase das Potential des Zeilenleiters auf einem ersten Pegel (VL1) festzulegen, in einer zweiten Lesephase das Potential des Zeilenleiters auf einem zweiten Pegel (VL2) festzulegen und in einer dritten Potentialrückstellphase das Potential des Zeilenleiters auf einen dritten Pegel (VL0) zu bringen.

12. Matrix nach Anspruch 11 dadurch gekennzeichnet, daß die Potentialdifferenz zwischen dem ersten und dritten Pegel absolut gesehen geringer als die Potentialdifferenz zwischen der Potentialrückstellspannung und einem Bezugspotential der Spaltenleiter ist.

13. Matrix nach Anspruch 12 dadurch gekennzeichnet, daß die Potentialdifferenz zwischen dem zweiten und ersten Pegel absolut gesehen größer als die Potentialdifferenz zwischen der Potentialrückstellspannung und einem Bezugspotential der Spaltenleiter ist.

## Claims

1. Matrix of photosensitive points including an array of photosensitive points (Pij) arranged in lines (at least one line) and in columns (at least one column), each photosensitive point being situated at the cross-roads of a line and of a column and being able, between two successive read phases, to integrate electric charges resulting from the illumination of this point, characterised in that each photosensitive point comprises three diodes (DP, DL, DR) linked to a common floating node (A), a first diode (DP), termed photosensitive diode, being linked between a line conductor (LLi) and the floating node (A) in order, when it is illuminated, to generate electrical charges on the floating node, a second diode (DL), termed read diode, linked between the floating node and a column conductor (Cj) for allowing a transfer, between this column conductor and the floating node, of a quantity of charges corresponding to the quantity of charges generated by the illumination between two successive read phases of the point, and a third diode (DR), termed level-reset diode, connected between the floating node and a conductor linked to a level-reset voltage source, for re-establishing the potential of the floating node at a chosen value after the said transfer of charges.

2. Photosensitive matrix according to Claim 1, characterised in that the level-reset voltage source is a fixed voltage source (VR).

3. Matrix according to Claim 2, characterised in that the anode of the photosensitive diode, the ande of the read diode and the cathode of the level-reset diode are linked to the common node, or conversely; the cathode of the photosensitive diode, the cathode of the read diode and the anode of the level-reset diode are linked to the common node.

4. Matrix according to Claim 2, characterised in that a means is provided for applying to the line conductor a read pulse having an amplitude which, in absolute value, is greater than the absolute value of the potential difference between the reference voltage source and a reference potential at which the column conductor is held.

5. Matrix according to Claim 1, characterised in that the cathode of the photosensitive diode, the anode of the read diode and the cathode of the level-reset diode are connected to the floating node, or conversely that the anode of the photosensitive diode, the cathode of the read diode and the anode of the level-reset diode are connected to the floating node.

6. Matrix according to Claim 5, characterised in that the level-reset voltage source is linked to another line conductor (LRi), and in that a means (DEL) is provided for applying a read pulse, at the end of a charge integration period, to the first line conductor mentioned and a level-reset voltage pulse to the other line conductor following the read pulse.

7. Matrix according to Claim 6, characterised in that the read pulse has a greater amplitude than the level-reset pulse.

8. Matrix according to Claim 6, characterised in that the read pulse and the level-reset pulse have the same amplitude and the same high and low potential levels.

9. Matrix according to Claim 8, characterised in that the other line conductor (LRi), linked to the level-reset diode of a photosensitive point of a defined line, is the first line conductor (LLi+1) linked to the photosensitive diode of a photosensitive point of another line of the matrix.

10. Matrix according to one of Claims 1 to 9, characterised in that a means is provided for applying to the line conductor a read voltage pulse of a first sign with respect to a reference potential applied to the column conductor during a charge integration phase, and simultaneously with the read pulse, a selection voltage pulse of the opposite sign applied to a specified column conductor linked to the photosensitive point in question, the other column conductors being held at the reference potential during this selection pulse.

11. Matrix according to Claim 2, characterised in that the cathode of the photosensitive diode, the anode of the read diode and the cathode of the level-reset diode are linked to the common node, or conversely, the anode of the photosensitive diode, the cathode of the read diode and the anode of the level-reset diode are linked to the common node, and in that a means is provided for applying to the line conductor a potential variation cycle including a first charge integration phase in which the potential of the line conductor is at a first level (VL1), a second read phase in which the potential of the line conductor is at a second level (VL2), and a third level-reset phase in which the potential of the line conductor is at a third level (VL0).

12. Matrix according to Claim 11, characterised in that the potential difference between the first and thir levels is, in absolute value, lower than the potential difference between the level-reset voltage source and a reference potential of the column conductors.

13. Matrix according to Claim 12, characterised in that the potential difference between the second and first levels is higher in absolute value than the potential difference between the level-reset voltage source and a reference potential of the column conductors.
